# EUROPÄISCHE PATENTSCHRIFT

(11) **EP 2 924 585 B1**
(45) Veröffentlichungstag und Bekanntmachung des Hinweises auf die Patenterteilung: **28.04.2021**
(21) Anmeldenummer: 15158584.1
(22) Anmeldetag: 11.03.2015
(51) Int. Cl.: G06F 30/23, H03M 7/30, G01M 17/007

(54) **Verfahren zum Betreiben eines Fahrzeugcrash - Testdatenmanagementsystems**
Method for operating a vehicle crash test data management system
Procédé de fonctionnement d'un système de gestion de données d'essais de collision de véhicules

(30) Priorität: 19.03.2014 DE 102014103768
(43) Veröffentlichungstag der Anmeldung: 30.09.2015
(73) Patentinhaber: SIDACT GmbH, 53757 Sankt Augustin (DE)
(72) Erfinder: Mertler, Stefan, 53225 Bonn (DE); Müller, Stefan, 12489 Berlin (DE); Thole, Clemens-August, 53229 Bonn (DE)
(74) Vertreter: Kohlhof, Stephan

(56) Entgegenhaltungen:
- WO-A1-2005/055146
- US-A1- 2002 103 622
- US-B1- 6 606 095
- LENGYEL J E ED - SPENCER S N (ED): "COMPRESSION OF TIME-DEPENDENT GEOMETRY", PROCEEDINGS OF THE 1999 SYMPOSIUM ON INTERACTIVE 3D GRAPHICS. ATLANTA, GA, APRIL 26 - 28, 1999; [PROCEEDINGS OF THE SYMPOSIUM ON INTERACTIVE 3D GRAPHICS], NEW YORK, NY : ACM, US, 26. April 1999 (1999-04-26), Seiten 89-95,226, XP001033619, ISBN: 978-1-58113-082-9
- Pai-Feng Lee ET AL: "Compression of 3D Animation by Principal Component Analysis", 4th International Conference in IT & Applications (ICATA 2007), 15. Januar 2007 (2007-01-15), Seiten 483-488, XP055208951, Harbin, China Gefunden im Internet: URL:http://www.icita.org/previous/icita200 7/papers/1318-tw.pdf [gefunden am 2015-08-21]
- BASTIAN BOHN ET AL: "Analysis of Car Crash Simulation Data with Nonlinear Machine Learning Methods", PROCEDIA COMPUTER SCIENCE, Bd. 18, 5. Juni 2013 (2013-06-05), Seiten 621-630, XP055208959, ISSN: 1877-0509, DOI: 10.1016/j.procs.2013.05.226
- Clemens-August Thole ET AL: "Advanced Mode Analysis for Crash Simulation Results", LS-DYNA Forum, Bamberg, 12. Oktober 2010 (2010-10-12), XP055012950, Gefunden im Internet: URL:http://www.dynamore.de/de/download/pap ers/forum10/papers/I-I-02.pdf [gefunden am 2011-11-23]
- Junhui Hou ET AL: "CLRMA: Compact Low Rank Matrix Approximation for Data Compression", , 7. Juli 2015 (2015-07-07), XP055209511, Gefunden im Internet: URL:http://arxiv.org/abs/1507.01673 [gefunden am 2015-08-25]
- STEFAN MERTLER ET AL: "Predictive Principal Component Analysis as a Data Compression Core in a Simulation Data Management System", 2015 DATA COMPRESSION CONFERENCE, 7. April 2015 (2015-04-07), Seiten 173-182, XP055209514, DOI: 10.1109/DCC.2015.50 ISBN: 978-1-47-998430-5
- JEROME EDWARD LENGYEL ED - SPENCER S N (ED): "Compression of time-dependent geometry", PROCEEDINGS OF THE 1999 SYMPOSIUM ON INTERACTIVE 3D GRAPHICS. ATLANTA, GA, APRIL 26 - 28, 1999; [PROCEEDINGS OF THE SYMPOSIUM ON INTERACTIVE 3D GRAPHICS], NEW YORK, NY : ACM, US, 26 April 1999 (1999-04-26), pages 89-95, XP058140567, DOI: 10.1145/300523.300533 ISBN: 978-1-58113-082-9

## Beschreibung

Die Erfindung betrifft ein Verfahren zum Betreiben eines Fahrzeugcrash - Testdatenmanagementsystems zur Kompression, Speicherung und Rekonstruktion von Beobachtungen einer Vielzahl von Fahrzeugcrash - Testabläufen, insbesondere von Fahrzeugcrash - Simulationsabläufen. Insbesondere handelt es sich um eine verlustbehaftete Kompression, bei der insbesondere eine vorgegebene Genauigkeit eingehalten wird.

Die Erfindung ist insbesondere anwendbar auf Simulationen von Testabläufen von Fahrzeugcrashtests. Zur Vorbereitung solcher Simulationen wird die Geometrie von Baugruppen des Fahrzeugs oder des vollständigen Fahrzeugs durch Bildung finiter Elemente mit einer Vielzahl von Knotenpunkten approximiert. Die Position der Knotenpunkte wird durch Knotenpunktkoordinaten definiert. Während der Simulation ändern sich die Positionen der Knotenpunkte und damit deren Knotenpunktkoordinaten. Zur Dokumentation der Simulationsergebnisse können zu einem die ursprünglichen sowie die geänderten Knotenpunktkoordinaten gespeichert werden, was einen großen Bedarf an Speicherplatz generiert. Zum anderen können solche Informationen gespeichert werden, aus denen sich die Knotenpunktkoordinaten rekonstruieren lassen. Dies erfordert einen deutlich geringeren Bedarf an Speicher. Die vorliegende Erfindung beschränkt sich auf die zweitgenannte Möglichkeit. Für die Erfindung geeignete Tests weisen zu jedem der Vielzahl von Testabläufen identische initiale Ausgangszustände auf.

In Clemens-August Thole ET AL: "Advanced Mode Analysis for Crash Simulation Results", XP055012950, wird Datenmanagement für reduzierte Daten aus Crash Simulationen offenbart. In LENGYEL ET AL: "COMPRESSION OF TIME-DEPENDENT GEOMETRY", XP001033619, und Pai-Feng Lee ET AL: "Compression of 3D Animation by Principal Component Analysis", XP055208951, werden Verfahren zur Kompression von zeitabhängigen Geometrien offenbart.

Die DE 103 31 431 B4 offenbart ein Verfahren zur Datenkompression von Simulationsergebnissen. In einer möglichen Variante wird dort jeweils ein Mittelwert für die Koordinaten einer Gruppe von Knotenpunkten ermittelt. Für die unterschiedlichen Zustände vor, während und nach der Simulation wird dann für jede Gruppe die jeweilige Differenz zum Mittelwert berechnet, quantisiert und codiert abgespeichert. Durch die Codierung ergibt sich eine Reduktion der abzuspeichernden Datenmenge.

Die Kompressionsrate, die sich mit dem vorgenannten Verfahren erreichen lässt, ist zwar beträchtlich; dennoch ergibt sich der Bedarf an einer verbesserten Kompressionsrate, um auch künftigen Anforderungen gerecht zu werden, die eine feinere Approximierung der zugrundeliegenden Geometrie und eine höhere Anzahl der zu archivierenden Simulationsergebnisse erfordern, insbesondere mit einer Einstellbarkeit der Präzision.

Es ist Aufgabe der Erfindung, ein verbessertes Verfahren zum Betreiben eines Fahrzeugcrash-Testdatenmanagementsystems zur Kompression, Speicherung und Rekonstruktion von Beobachtungen einer Vielzahl von Testabläufen bereitzustellen. Die der Erfindung zugrunde liegende Aufgabe wird gelöst durch ein Verfahren nach Anspruch 1; bevorzugte Ausgestaltungen ergeben sich aus den Unteransprüchen.

Bei den Beobachtungen handelt es sich die Gesamtheit von skalaren Werten an bestimmten Instanzen des Tests zu verschiedenen Beobachtungspunkten. Eine Beobachtung ist eine Art Snapshot des Testablaufs. Ein Beobachtungspunkt kann ein Zeitpunkt innerhalb eines Testablauf mit einem oder mehreren Zeitpunkten sein. Ein Beobachtungspunkt kann auch zeitpunktunabhängig sein; eine entsprechende Beobachtung eines zeitpunktunabhängigen Beobachtungspunkts umfasst z.B. Parameter des Testablaufs, die sich über die Zeit nicht ändern.

Als Instanz wird in Knotenpunkt oder eine Kante verstanden, in die ein räumliches Gitters unterteilt ist. Der Instanz sind wiederum einzelne Instanzenkoordinaten (im Folgenden auch Koordinaten) zugeordnet, beispielsweise die Knoten- oder Kantenkoordinaten. Bei den Koordinaten handelt es sich insbesondere um räumliche x-, y- oder z-Koordinaten der Instanz, die während eines Testablaufs eine Form- oder Lageveränderung erfährt und/oder um andere physikalische Größen, wie zum Beispiel Geschwindigkeiten, Drücke, Schädigungswerte oder Temperaturen, welche der Instanz zugeordnet sind.

Beim Aufteilen der Instanzen in Instanzengruppen kann jede Instanz sowohl exakt einer als auch mehreren Gruppen zugeordnet werden. Dabei enthält jede Instanzengruppe mindestens eine, vorzugsweise zumindest zwei Instanzen, für die in den betrachteten Beobachtungen auch Instanzenkoordinaten vorliegen.

Grundsätzlich kann zur Ermittlung der Basismatrix und der Koeffizientenmatrix die Hauptkomponentenanalyse angewendet werden, die ein bereits bekanntes und vielseitig eingesetztes Werkzeug zur Vereinfachung von umfangreichen Datensätzen ist. So verwendet auch die US 6,606,095 B1 die Hauptkomponentenanalyse zur Codierung einer Matrix, welche jedoch nur die Daten einer zeitveränderlichen Geometrie umfasst, wohingegen in der hier vorliegenden Anmeldung eine Vielzahl solcher Veränderungen der selben Geometrie betrachtet werden. Das dort beschriebene Verfahren setzt die Hauptkomponentenanalyse aber auf eine Matrix an, die den gesamten Datenbestand abbildet, ohne eine vorherige Extrahierung gleichartiger Koordinaten und die Separierung auf einzelne Instanzengruppen vorzunehmen. Dies vergrößert den Datensatz, der der Hauptkomponentenanalyse zugeführt wird und erzeugt unter Umständen einen riesigen Satz von Basisvektoren und Gewichtswerten, welcher gegenüber der ursprünglich zu codierenden Daten keine wesentliche Einsparung im Datenaufkommen darstellt. Desweiteren wird die superlineare Laufzeit des Verfahrens durch die Separierung reduziert. Ferner befasst sich die US 6,606,095 B1 mit einem einzelnen Vorgang und nicht mit einer Vielzahl von Abläufen mit teils identischer initialer Geometrie.

Erfindungsgemäß ist im Gegensatz zur US 6,606,095 B1 nun vorgesehen, dass zunächst der Datenbestand in Instanzengruppen aufgeteilt wird. Anschließend werden je Gruppe gleichartige, also die koordinatenartgleichen Koordinaten aus dem erzeugten Datensatz extrahiert und den jeweiligen Beobachtungsmatrizen zugeführt. Eine Beobachtungsmatrix enthält folglich z.B. sämtliche x-Koordinaten der Knotenpunkte einer Knotengruppe (z.B. eines Bauteils), die im Rahmen des Testablaufs (auch simulationsübergreifend) vorkommen. Erst anschließend erfolgt die Hauptkomponentenanalyse und zwar für jede der Beobachtungsmatrizen separat. Es werden also die Richtungsänderungen separat der Hauptkomponentenanalyse (oder einer anderen Art der Erzeugung der Basismatrix bzw. Koeffizientenmatrix) zugeführt.

Dabei werden den Instanzenkoordinaten jeweils exakt eine Koordinatenarten zugeordnet, derart, dass pro Instanz und Beobachtung maximal eine Instanzenkoordinate mit der jeweiligen Koordinatenart existiert. So weisen z.B. alle beobachteten Druckwerte, x-Werte, y-Werte, z-Werte jeweils dieselbe Koordinatenart auf.

Dadurch, dass insbesondere im Rahmen einer Fahrzeugcrashsimulation die Menge von gleichartigen Koordinaten einer Gruppe sowohl innerhalb eines Crashs als auch crashtestübergreifend und zu verschiedenen Zeitpunkten häufig identisch oder zumindest recht ähnlich sind, ergibt sich eine gute Grundlage für eine Datenkompression der beanspruchten Art. Dies betrifft insbesondere den Anwendungsfall von Crashtestsimulationen, die häufig aber mit lediglich geringfügigen Abweichungen wiederholt werden.

Dies führt in einem idealisierten Fall zu folgendem Vorteil. Ein Bauteil wird in einer Vielzahl von Crashtests eingesetzt, die aber allesamt zu einer identischen Verformung in y-Richtung (Fahrzeugbreite) dieses Bauteils führen. In anderen Richtungen können sich in den einzelnen Tests teils signifikante unterschiedliche Verformungen ergeben. Da für dieses Bauteil nun eine separate Hauptkomponentenanalyse in y-Richtung durchgeführt wurde, ergibt sich für dieses Bauteil im optimalen Fall der Datenaufwand für die y-Koordinaten in Form der reduzierten Basismatrix und der reduzierten Koeffizientenmatrix lediglich in der Größe eines einzelnen Basisvektors. Würde man die Aufteilung in Instanzengruppen nicht durchführen, so würde aufgrund der Bewegung von anderen Bauteilen in y-Richtung eine Vielzahl von Basisvektoren entstehen, die jeweils auch Werte für die y-Koordinaten dieses spezifischen Bauteils enthalten, was deutlich mehr Speicherplatz erfordert.

Die Erfindung bezieht sich insbesondere auf ein Datenkompressionsverfahren, das einen Datensatz nicht notwendigerweise identisch sondern nur bis auf eine vorgegebene Genauigkeit rekonstruieren lässt. Somit ist dieses Verfahren insbesondere ein verlustbehaftetes Datenkompressionsverfahren. Vorzugsweise ist somit die Genauigkeit des Verfahrens einstellbar.

Die Genauigkeit kann hierbei auf vielfältige Weise gefordert werden. Ein Spezialfall ist den absoluten Unterschied zwischen originalem und rekonstruiertem Wert zu beschränken. Spezielle Postprocessing Anwendungen wie u.a. Visualisierung, Optimierungen und Kennzahlenberechnungen können dazu führen, dass die Anforderungen an die Genauigkeit durch komplexere Zusammenhänge als der soeben genannte beschrieben werden können und sich dessen Berücksichtigung in der Kompressionsrate positiv auswirken kann. Falls die Anforderungen lediglich bezüglich des absoluten Unterschieds zwischen originalem und rekonstruiertem Wert getroffen wird bietet sich eine Quantisierung der vorliegenden Werte an, bei der die Anzahl der Werte die angenommen werden können reduziert wird. Als zweiter Schritt wird oft eine Vorhersage in Abhängigkeit des örtlichen und zeitlichen Zusammenhangs durchgeführt und lediglich der Fehler der Vorhersage abgespeichert. Falls die Vorhersage geeignet gewählt wurde, ist die Anzahl der verschiedenen angenommen Werte des Fehlers deutlich geringer als die der Quantisierten. Die hohe Wiederholungsrate von Werten kann man mit einem geeignetem Codierer, wie zum Beispiel einem algorithmischen bzw. arithmetischen Codierer, Huffman Codierer oder viele andere, ausnutzen. Der Codierer (insbesondere der Huffmann Codierer) kann hierbei einer Zahl eine eindeutige Repräsentanz in einem binären Alphabet so zuweisen, dass die Daten eindeutig durch einen zugehörigen Decodierer rekonstruiert werden. Falls die Quantisierung, Vorhersage und Codierung geeignet zu den vorliegenden Daten gewählt wurden, können folglich gute Kompressionsraten erreicht werden.

Falls die Anforderungen an die Genauigkeit durch einen komplexeren Zusammenhang beschrieben werden, bieten sich oft Verfahren an, bei denen nicht im ersten Schritt eine Quantisierung vorgenommen wird. Für diese Klasse stehen zum Beispiel die Verfahren "Highpass-Quanitzation" und die "Mesh-Deformation", die insbesondere in der Visualisierung ihre Anwendung finden.

Vorzugsweise wird die Beobachtungsmatrix vor der Bestimmung der Basismatrix und der Koeffizientenmatrix zentriert. Hierbei werden insbesondere zeilenweise Mittelwerte der Beobachtungsmatrix erzeugt, und von den entsprechenden Werten der entsprechenden Zeilen der Beobachtungsmatrix abgezogen. Diese Mittelwerte können dann verlustbehaftet, komprimiert, insbesondere quantisiert und codiert, abgespeichert werden.

Die reduzierte Basismatrix und die reduzierte Koeffizientenmatri> werden jeweils separat abgespeichert. Diese separate Speicherung ermöglicht das örtlich unabhängige Lagern und "zur Verfügungstellen" der Basismatrix und der Koeffizientenmatrix. So ist es zwar für eine Rekonstruktion erforderlich, dass die Basismatrix weitgehend vollständig am Ort der Rekonstruktion verfügbar ist; zur Rekonstruktion reicht es allerdings aus, dass die Koeffizientenmatrix nur insoweit örtlich verfügbar ist, als dass die verfügbaren Teile die Elemente umfassen, die den zu rekonstruierenden Testablauf oder einen Zeitpunkt daraus umfassen. Vor der Speicherung kann die reduzierte Basismatrix und/oder die reduzierte Koeffizientenmatrix ihrerseits verlustbehaftet komprimiert, insbesondere quantisiert und codiert, werden.

Die Koeffizientenmatrix wird testablaufweise abgespeichert, also für jeden der 1...m Testabläufe separat. Das bedeutet, dass in einer Datei lediglich die testablaufspezifischen Koeffizientenwerte eines einzigen Testablaufs hinterlegt sind. Gemeinsam mit der reduzierten Basismatrix, die die Basisvektoren aller Testabläufe umfasst, genügt dann folglich ein Teil der reduzierten Koeffizientenmatrix, um sämtliche zeitpunktabhängigen Beobachtungen eines einzigen Testablaufs für eine Instanzengruppe zu rekonstruieren. Obwohl die Koeffizientenmatrix einen sehr großen Teil des Datenaufkommens darstellt, ermöglicht diese Aufteilung, dass ein kurzfristig nachgefragtes Testergebnis schnell bereit gestellt werden kann, sofern die reduzierte Basismatrix verfügbar ist. Hierbei wird der Umstand ausgenützt, dass mit jedem weiteren Test zwar die Koeffizientenmatrix zwangsläufig weiter anwächst; die Basismatrix wächst allerdings nur dann an, wenn sich durch den weiteren Test neue abzuspeichernde Basisvektoren ergeben.

Vorzugsweise ist vorgesehen, dass sämtliche Werte der reduzierten Basismatrix gemeinsam abgespeichert werden. Die Elemente innerhalb der Basismatrix sind grundsätzlich nicht einzelnen Testabläufen zugeordnet; vielmehr sind einzelne Elemente zumeist relevant für die Rekonstruktion von einer Vielzahl von Testabläufen. Insofern ist es vorteilhaft, wenn die Basismatrix für die Rekonstruktion vollständig zur Verfügung steht.

Vorzugsweise wird durch Multiplikation der reduzierten, insbesondere verlustbehaftet komprimiert und dekomprimierten, Basismatrix mit der reduzierten, und insbesondere verlustbehaftet komprimiert und dekomprimierten, Koeffizientenmatrix eine Approximationsmatrix der jeweiligen Beobachtungsmatrizen erzeugt. Hiermit wird nun eine Fehlermatrix ermittelt, indem von der Beobachtungsmatrix zum einen diese Approximationsmatrix und zum anderen spaltenweise der Vektor der, insbesondere verlustbehaftete komprimierten und dekomprimierten Mittelwerte subtrahiert werden. Die Mittelwerte werden wie zuvor bereits beschrieben erzeugt.

Vorzugsweise werden die einzelne Fehlerwerte, also die Elemente der Fehlermatrix, für jeden Testablauf separat abgespeichert. Da die Fehlerwerte jeweils nur Relevanz bezüglich eines einzigen Testablaufs haben werden zur Rekonstruktion dieses Testablaufs auch nur die entsprechenden Fehlerwerte benötigt. Diese können vorzugsweise auch gemeinsam, z.B. in einer testablaufspezifischen Containerdatei, mit den testablaufspezifischen Werten der reduzierten Koeffizientenmatrix abgespeichert werden, die ebenfalls, wie oben beschrieben, für die Rekonstruktion eines einzigen Testablauf erforderlich sind.

Vorzugsweise werden Werte zur, insbesondere approximativen, Rekonstruktion von Beobachtungen von weiteren Testabläufen ausschließlich in separaten Dateien abgelegt. Approximative Rekonstruktion bedeutet, dass die rekonstruierte Beobachtung nicht mit der ursprünglichen Beobachtung exakt übereinstimmen muss. Dies ermöglicht die universelle Erweiterbarkeit des gesamten komprimierten Datenbestandes, der eine Vielzahl von Testabläufen umfasst. Dabei stellt die oben beschriebene Basismatrix sowie die reduzierte Koeffizientenmatrix sozusagen eine Art initialer Grunddatenbestand dar (im nachfolgenden initiale Basismatrix und initiale reduzierte Koeffizientenmatrix), der nun durch neu erzeugten Datenbestand aus weiteren Testabläufen ergänzt wird. Dies bedeutet, dass die initialen Dateien, in denen die initiale Basismatrix und in denen die Werte der initialen reduzierten Koeffizientenmatrix abgespeichert sind, nicht durch irgendwelche Werte aus den neuen Testabläufen ergänzt werden. Vielmehr werden die Werte aus den neuen Testabläufen in neuen Dateien, also den separaten Dateien abgelegt. Dies hat den Vorteile, dass insbesondere die Basismatrix nicht vollständig aktualisiert werden muss und ggf. wieder um die Welt verschickt werden muss; vielmehr reicht es aus, dass neue Dateien mit Basismatrix-Erweiterungswerten, insbesondere Erweiterungsbasisvektoren, neben der initialen Datei umfassend die initiale Basismatrix vorgehalten werden muss. Auch die neuen Koeffizientenwerte und Fehlerwerte, sind analog zur den initialen Werten jeweils nur einem einzelnen Testablauf zugeordnet und werden daher separat abgespeichert.

Hierfür ist vorzugsweise vorgesehen, dass anhand einer Projektion einer neuen, insbesondere zentrierten, Beobachtungsmatrix umfassend Koordinatenwerte eines neuen Datensatzes, mit der (initialen) Basismatrix, die lediglich den Ursprungsdatensatz berücksichtigt, eine neue, insbesondere reduzierte, Basismatrix erzeugt wird, die lediglich Basisvektoren umfasst, die von der reduzierten initialen Basismatrix nicht umfasst sind. Diese neue reduzierte Basismatrix ist also der aufgrund des neuen Testablaufs erzeugte Rest des Gesamtbestandes an Basisvektoren, der durch die initiale Basismatrix noch nicht dargestellt werden kann. Diese neue Basismatrix wird nun separat abgespeichert. Zur Rekonstruktion von Instanzen eines beliebigen Testablaufs aus der Gesamtheit aller Testabläufe ist dann zum einen die Datei vorzuhalten, die die initiale Basismatrix umfasst. Gehört der zu rekonstruierende Testablauf zu den neuen Testabläufen ist zum anderen noch die entsprechende neue separate Basismatrixdatei vorzuhalten. Da diese neue separate Basismatrixdatei i.d.R. recht klein ist, kann diese auch kurzfristig über eine Datenverbindung von einem weit entfernten Server bezogen werden. Auch diese neue Basismatrixdatei kann verlustbehaftet komprimiert werden und ist in diesem Fall zur Rekonstruktion wieder zu dekomprimieren.

Vorzugsweise wird dann anhand der vorgenannten Projektion eine neue reduzierte Koeffizientenmatrix erzeugt. Diese neue reduzierte Koeffizientenmatrix umfasst dann lediglich Werte, die durch den neuen Testablauf generiert wurden. Zur Rekonstruktion eines Testablaufs aus dem initialen Datenbestand ist die neue reduzierte Koeffizientenmatrix nicht erforderlich, sondern lediglich zur Rekonstruktion dieses neuen Testablaufs. Auch die Werte der neuen reduzierte Koeffizientenmatrix können nun separat abgespeichert werden, insbesondere nach einer vorherigen verlustbehafteten Komprimierung.

Anschließend kann erneut eine Fehlerberechnung durchgeführt werden. Abweichend zur oben genannten Fehlerberechnung wird nun der neue Datenbestand zur Fehlerermittlung herangezogen, umfassend die initiale Basismatrix, die neuen Basismatrizen, die Mittelwerte und die neuen Koeffizientenmatrizen.

Vorzugsweise werden für einzelne Testabläufe diejenigen Basisvektoren, die sich auf unterschiedliche Instanzengruppen beziehen, in gemeinsamen, instanzengruppenübergreifenden Dateien abgespeichert oder Werte von Koeffizienten, die sich auf unterschiedliche Instanzengruppen beziehen, in gemeinsamen, instanzengruppenübergreifenden Dateien abgespeichert. So können relevante Werte zur Rekonstruktion eines Testablaufs gruppenübergreifend abgelegt werden. Zur Rekonstruktion von Instanzen mehrerer Gruppen eines Testablaufs ist somit lediglich nur eine Koeffizientendatei und/oder eine Basismatrixdatei erforderlich. Nicht zu verwechseln ist diese Maßnahme mit einer Vermischung von Basisvektoren und Koeffizienten gemeinsam in einer Datei oder einer Vermischung von Koeffizienten, die sich auf unterschiedliche Testabläufe beziehen, in einer Datei.

Ein der Erfindung zugrunde liegendes Fahrzeugcrash - Testdatenmanagementsystem umfasst eine Datenkompressionseinheit zur Datenkompression von Beobachtungen, einer Vielzahl von Fahrzeugcrash - Testabläufen zu einem oder mehreren Beobachtungspunkten, insbesondere Zeitpunkten, die insbesondere von einer Datengenerierungseinheit bereit gestellt werden, sowie eine Speichereinheit zum Abspeichern der von der Datenkompressionseinheit mittels der Datenkompression von Beobachtungen erzeugten Basismatrizen und Koeffizientenmatrizen, und insbesondere von Mittelwerten und von Elementen von Fehlermatrizen. Die Datengenerierungseinheit kann Bestandteil des Testdatenmanagementsystems sein. Die Datengenerierungseinheit kann einen realen Testaufbau und/oder eine Simulationsumgebung umfassen. Die abzuspeichernden Basismatrizen und die abzuspeichernden Koeffizientenmatrizen, und insbesondere die Mittelwerte und die Elemente der Fehlermatrizen, werden durch ein Verfahren der vorbeschriebenen Art erzeugt.

Zur Rekonstruktion einer Beobachtung an einer Arbeitsstatior werden einzelne Basismatrizen, Koeffizientenmatrizen, und insbesondere Mittelwerte und Elemente der Fehlermatrizen, von der Speichereinheit an die Arbeitsstation übermittelt.

Zur Rekonstruktion einer ausgewählten Beobachtung werden lediglich diejenigen testablaufspezifische Dateien eines testablaufspezifischen Datenbestandes von der Speichereinheit zur Arbeitsstation übertragen, zu deren Testablauf die ausgewählte Beobachtung gehört. Hierdurch wird die Gesamtmenge der an der Arbeitsstation 5 benötigten und dorthin zu übertragenden Daten auf ein Minimum reduziert da nicht der gesamte testablaufspezifische Datenbestand verfügbar sein muss. Neben einem Basisdatenbestand reicht somit eine recht kleiner Menge von testablaufspezifischen Daten aus, um eine ausgewählte Beobachtung an dieser Arbeitsstation 5 rekonstruieren zu können.

Die Erfindung wird anhand der Figuren nachfolgend näher erläutert, hierin zeigt
- Figur 1: eine Beobachtung;
- Figur 2: a) eine zu komprimierender Datensatz; b) eine Koordinate des Datensatzes;
- Figur 3: die Aufteilung des Datensatzes in einzelne Beobachtungsmatrizen;
- Figur 4: eine Beobachtungsmatrix in allgemeiner Ausführung;
- Figur 5: die Zentrierung der Beobachtungsmatrix;
- Figur 6: die Zerlegung der zentrierten Beobachtungsmatrix in a) eine Basismatrix und eine Koeffizientenmatrix, b) eine reduzierte Basismatrix und eine reduzierte Koeffizientenmatrix;
- Figur 7: die Codierung und das Abspeichern der reduzierte Basismatrix und der reduzierte Koeffizientenmatrix in separaten Dateien;
- Figur 8: die Berechnung und das Abspeichern des Rekonstruktionsfehlers;
- Figur 9: Erzeugung einer neuen Beobachtungsmatrix, die Koordinaten von neuen Testabläufen umfasst;
- Figur 10: die Projektion der neuen zentrierten Beobachtungsmatrix mit der quantisierten und dequantisierten alten reduzierten Basismatrix;
- Figur 11: Erzeugung einer projizierten Beobachtungsmatrix;
- Figur 12: die Zerlegung der projizierten Beobachtungsmatrix in eine neue reduzierte Basismatrix und eine neue reduzierte Koeffizientenmatrix sowie deren Codierung und Abspeichern in separaten Dateien;
- Figur 13: Erzeugen einer neuen Rekonstruktionsfehlermatrix sowie deren Codierung und Abspeichern deren Fehlerwerte in separaten Dateien,
- Figur 14: schematisch die Anordnung eines Simulationsdatenmanagementsystems im Umfeld einer Test- und Auswerteumgebung.

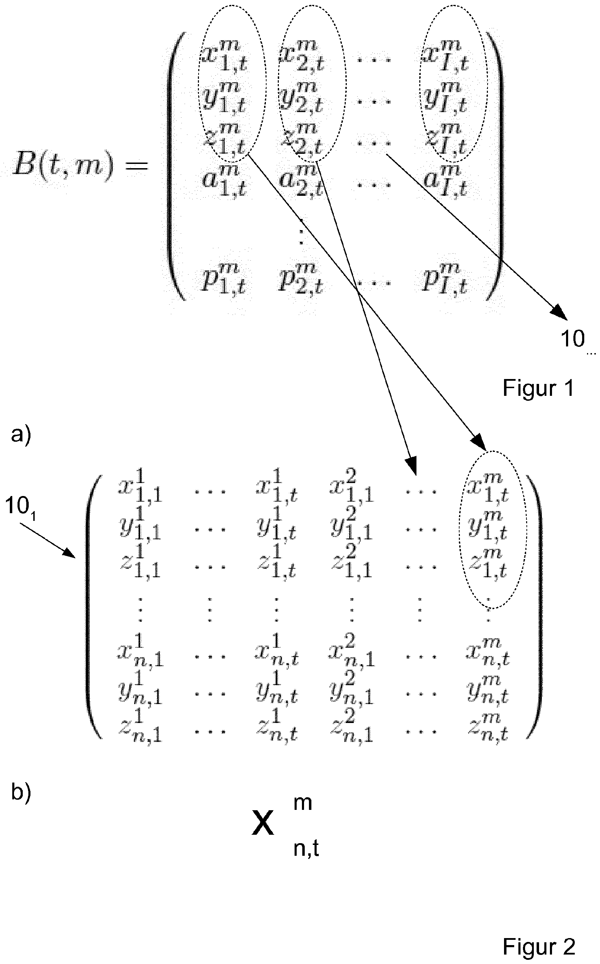

Die Figuren 1 und 2 werden nachfolgend gemeinsam beschrieben. Figur 1 zeigt die Beobachtung B eines Gitters, welches einem Test unterzogen wird. Die Beobachtung umfasst alle Instanzen, im vorliegenden Fall Knotenpunkte, zu einem bestimmten Zeitpunkt t während eines bestimmten Testablaufs aus den Testabläufen 1..m. In jeder Spalte sind sämtliche Instanzenkoordinaten x, y, z, a...p aufgeführt. Die Koordinaten x, y, z stellen Raumkoordinaten des Knotenpunkts dar und legen somit dessen Position fest. Die Koordinate a bezeichnet die am Knoten wirkende Beschleunigung, die Koordinate p den am Knoten wirkenden Druck. Im Rahmen des nachfolgend beschriebenen Ausführungsbeispiels werden der Einfachheit halber nur die Raumkoordinaten x,y,z weiter behandelt. Während der späteren Rekonstruktion sollen einzelne oder mehrere der Beobachtungen B wieder hergestellt werden. Im vorliegenden Fall umfasst die Beobachtung lediglich zeitpunktabhängige Koordinaten. Es können aber auch Beobachtungen vorliegen, die zusätzlich oder nur zeitpunktunabhängige Instanzenkoordinaten umfassen. Der gesamte zu komprimierende Datenbestand wird nun durch solche Beobachtungen B gebildet.

Anschließend wird die Menge aller Beobachtungen B aufgeteilt in einzelne Datensätze 10, wie in Figur 2a gezeigt ist. Diese umfasst sämtliche Knotenkoordinaten x, y, z einer Instanzengruppe, im vorliegenden Fall einer Knotengruppe. Eine solche Knotengruppe umfasst die Knoten eines Bauteils, einer Baueinheit oder von Teilen eines Bauteils. So gehören im vorliegenden Fall die Instanzen mit dem Index 1 ...n zur selben Knotengruppe; deren Koordinaten werden daher in dem selben Datensatz 10 abgelegt. Die Instanzen mit dem Index n+1 ... I gehört zu einer anderen Knotengruppe; deren Koordinaten wird daher in einem anderen Datensatz 10 abgelegt, was durch den nach 10... weisenden Pfeil visualisiert ist. Es können einzelne Knoten auch mehreren Instanzengruppen zugeordnet werden, insbesondere wenn ein Knoten ein Teil von mehreren Bauteilen ist.

Die Knotenkoordinaten x, y, z sind zur Unterscheidung mit den Indizes m, n, t versehen, die anhand Figur 2b vorgestellt werden:
x bezeichnet jeweils die x-Raumkoordinate der Position eines Knotenpunktes zu einem bestimmten Zeitpunkt 1..t; durch drei Raumkoordinaten x, y, z wird folglich die Knotenposition zu einem bestimmten Zeitpunkt 1..t definiert.

Der Index 1..n individualisiert einen bestimmten Knotenpunkt innerhalb einer Knotengruppe. Die beobachtete Knotengruppe umfasst somit n Knotenpunkte.

Der Index 1..m individualisiert einen Testablauf, der wiederum t Zeitpunkte umfasst. Insgesamt berücksichtigt der Datensatz also m x t Zeitpunkte. Insofern umfasst der Datensatz daher (n x m x t) x-Knotenkoordinaten, insgesamt folglich 3 x (n x m x t) Knotenkoordinaten. Lediglich zur Vereinfachung der Notation wird vorliegend angenommen, dass sämtliche Testabläufe über eine identische Anzahl von Zeitpunkten verfügen, was aber nicht erforderlich ist.

Die Art, wie die Gruppeneinteilung vorgenommen werden kann, wird weiter unten noch näher erläutert.

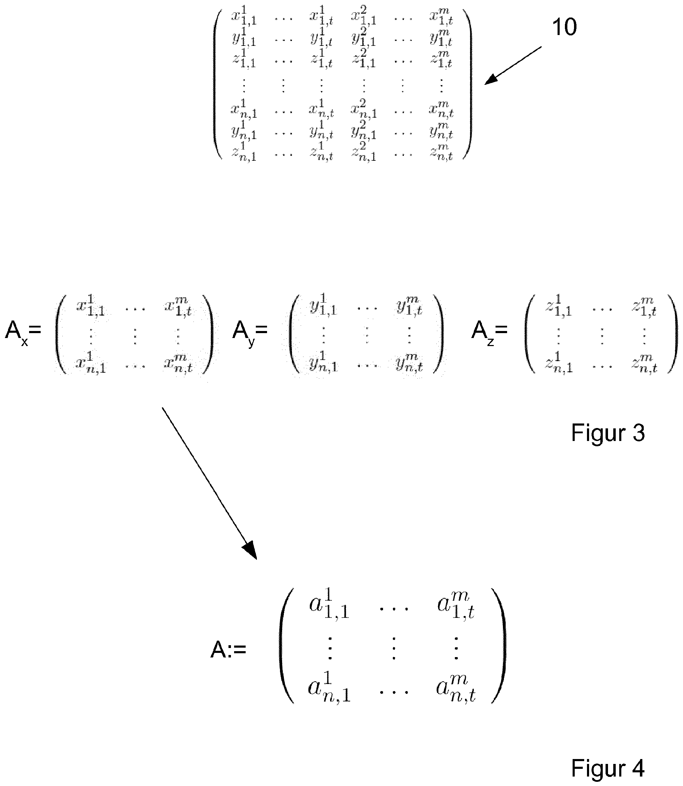

Figur 3 verdeutlicht die weitere Aufteilung des Datensatzes 10 in Beobachtungsmatrizen A. Hierbei wird der Datensatz 10 in seine x-Knotenkoordinaten, seine y-Knotenkoordinaten und seine z-Koordinaten aufgeteilt. Diese Koordinaten werden separat jeweils einer richtungsbezogenen Beobachtungsmatrix Aₓ, A_{y}, A_{z} zugeführt. Jede der richtungsbezogenen Beobachtungsmatrizen A umfasst folglich alle Knotenkoordinaten einer Richtung x, y, z, für eine Knotengruppe (Anzahl n) über alle Zeitpunkte (Anzahl t) aller Testläufe (Anzahl m).

Die weitere Verarbeitung der Beobachtungsmatrizen A findet identisch für jede richtungsbezogene Beobachtungsmatrix Aₓ, A_{y}, A_{z} statt. Allgemein wird daher stellvertretend für die Koordinaten x, y, z nun der Buchstabe a verwendet; die Beobachtungsmatrix A (ohne Index) dient im Folgenden der Erläuterung derjenigen Maßnahmen, die für alle Beobachtungsmatrizen Aₓ, A_{y}, A_{z} gleichermaßen durchzuführen sind (Figur 4). Liegt in einer Beobachtung an einer Instanz der betrachteten Gruppe keine Koordinate der betrachteten Koordinatenart vor, so wird dieser Wert sinnvoll ergänzt, beispielsweise durch Interpolation aus benachbarten Instanzen oder es wird der Wert 0 zugewiesen.

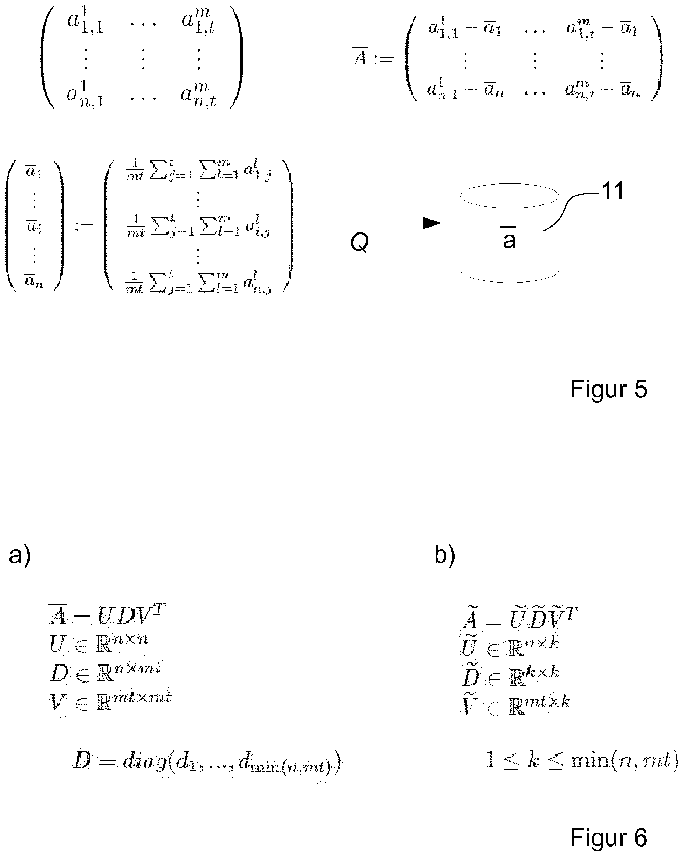

Die Beobachtungsmatrix A wird nun zentriert (Figur 5). Hierfür werden zunächst Mittelwerte a̅₁, a̅₂, ... a̅ₙ jeder Zeile der Beobachtungsmatrix A gebildet. Die einzelnen Koordinaten a werden von einem jeweiligen zeilenbezogenen Mittelwert a̅ anschließend subtrahiert und in einer zentrierten Beobachtungsmatrix A̅ abgelegt. Dieser zeilenbezogene Mittelwert stellt somit die Mittelung der jeweiligen Koordinate a über alle Zeitpunkte und Testläufe dar. Der Vektor der Mittelwerte a̅ der zentrierten Beobachtungsmatrix A̅ wird quantisiert (Schritt Q) und in einer Mittelwertdatei 11 abgelegt.

Anschließend wird eine Singulärwertzerlegung durchgeführt (Figur 6). Aus der zentrierten Beobachtungsmatrix A̅ wird eine Basismatrix U und eine Koeffizientenmatrix DV^{T} ermittelt (Figur 6a). Die Diagonalmatrix D umfasst die Singulärwerte d1, ... d_{(min (n, mt)}, welche von oben nach unten absteigend (d1=>d2 .. => d_{(min (n, mt)}) sortiert werden. Die Basismatrix und die Koeffizientenmatrix werden anhand einer zu ermittelnden Arbeitsdimension reduziert. Dies kann die intrinsische Dimension sein. Anhand dieser Arbeitsdimension erfolgt ein Herausfiltern von "wichtigen" Hauptkomponenten, d.h. solchen, die stets mit einem signifikanten Singulärwert zu multiplizieren sind, welche z.B. oberhalb eines vorgegebenen Schwellwerts liegen. Die übrigen Hauptkomponenten werden verworfen, in dem die entsprechenden Singulärwerte der Diagonalmatrix D auf NULL gesetzt werden. Die Bestimmung der Arbeitsdimension wird weiter unten noch näher erläutert.

Nun werden die ersten k (Anzahl) Spalten der Basismatrix U (entspricht einer reduzierte Basismatrix Ü) sowie die ersten k (Anzahl) Zeilen der Koeffizientenmatrix DV^{T} (entspricht einer reduzierten Koeffizientenmatrix DṼ^{T}) miteinander multipliziert, wodurch eine approximierte zentrierte Beobachtungsmatrix Ã erzeugt wird (Figur 6b). Die Dimension der approximierten zentrierten Beobachtungsmatrix Ã entspricht denen der zentrierten Beobachtungsmatrix A̅.

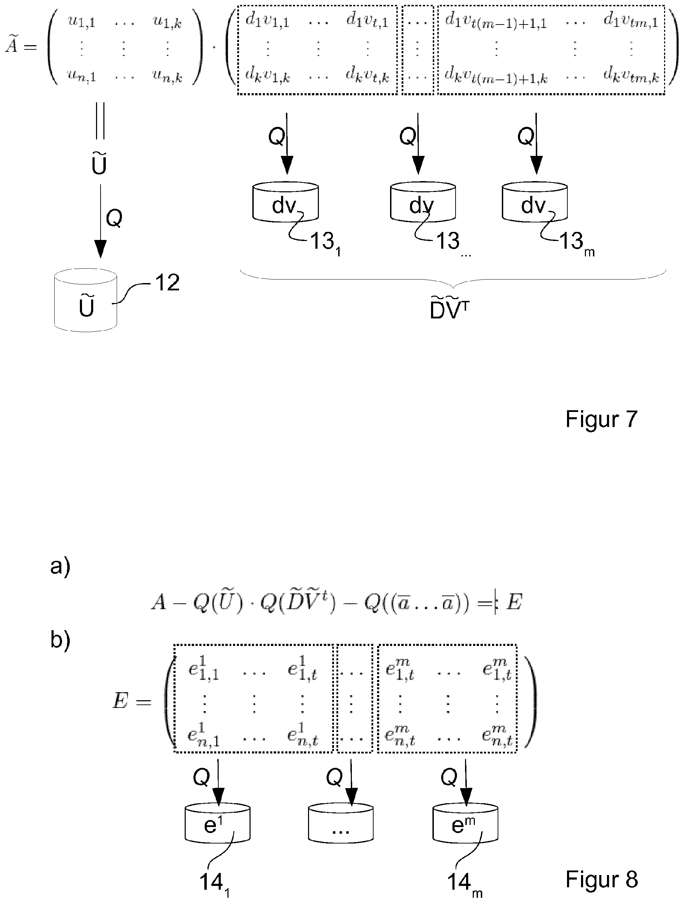

Figur 7 verdeutlicht noch einmal den Zusammenhang zwischen der zentrierten approximierten Beobachtungsmatrix Ã und der reduzierten Basismatrix Ũ bzw. reduzierten Koeffizientenmatrix DṼ^{T}. Die reduzierte Basismatrix Ũ wird nun quantisiert (Schritt Q) und in einer Basismatrixdatei 12 codiert abgespeichert. Die reduzierte Koeffizientenmatrix DṼ^{T} wird nun zerteilt in Elemente dv, die jeweils einem identischen Testablauf angehören, also für Elemente dv mit identischem Testablauf-Index aus 1..m. Sämtliche dieser Werte dv für diesen Testablauf bilden wiederum eine neue Matrix, die in Figur 7 durch jeweils ein gestricheltes Rechteck markiert sind. Diese Matrizen werden nun quantisiert (Schritt Q) und jeweils in einer Koeffizientendatei 13₁ ... 13ₘ codiert abgespeichert. Jede der Koeffizientendateien 13 enthält nun die Koeffizientenelemente dv für einen der Testabläufe aus 1..m. Zur Rekonstruktion der Geometrie zu irgendeinem Zeitpunkt eines Testablaufs ist neben der Basismatrixdatei 12 die Koeffizientendatei 13 des entsprechenden Testablaufs erforderlich; die anderen Koeffizientendateien 13, die anderen Testabläufen zugeordnet sind, sind zur Rekonstruktion dieses Testablaufes nicht erforderlich.

Grundsätzlich wäre es zwar denkbar, eine Koeffizientendatei 13 mit den Elementen für jeden einzelnen Zeitpunkt eines Testablaufs zu erstellen. Dies würde die Größe jeder einzelnen Koeffizientendatei 13 zwar deutlich reduzieren und eine schnellere Rekonstruktion der Geometrie zu diesem Zeitpunkt ermöglichen. Erfindungsgemäß wird aber die "testablaufweise" Koeffizientendatei 13 gegenüber der auch denkbaren "zeitpunktweisen" Koeffizientendatei vorgezogen, was folgenden Grund hat: Eine zeitpunktweise Abspeicherung der Koeffizientendatei 13 würde Werte bezüglich einer Vielzahl von Knotenkoordinaten umfassen, die aber allesamt zu unterschiedlichen Punkten gehören; denn pro Zeitpunkt wird jeder Knotenpunkt nur einmal abgespeichert. Die testablaufweise Abspeicherung in der Koeffizientendatei 13 umfasst hingegen Werte einer Vielzahl von identischen Knoten. Da die Knotenpunkte während eines Testablaufs teilweise nur geringe Relativbewegungen erfahren, nehmen die vielen Knotenkoordinaten eines Punktes vielfach identische oder nur geringfügig abweichende Werte innerhalb eines Testablaufs an. Diese Vielzahl von identischen Werten bildet aber nun die Basis für eine gute Datenreduktion in der nachfolgenden Codierung, die mit der testablaufweisen Abspeicherung ausgenutzt wird. Bei einer zeitpunktweisen Abspeicherung hingegen könnte dieses Potential nicht genutzt werden.

Anhand Figur 8 wird die Berechnung des Rekonstruktionsfehlers E erläutert: von der (nicht zentrierten, nicht approximierten) Beobachtungsmatrix A wird das Produkt aus, quantisierter und dequantisierter, reduzierter Basismatrix Ũ und, quantisierter und dequantisierter, reduzierter Koeffizientenmatrix DṼ^{T} subtrahiert. Von dieser Differenz wird dann von jeder Spalte der quantisierte und dequantisierte Vektor der Mittelwerte a̅ subtrahiert. Das Ergebnis ist der Rekonstruktionsfehler E (Figur 8a).

Die Elemente e der Rekonstruktionsfehlermatrix E werden anschließend für jeden Testablauf (testablaufbezogen) in einer Rekonstruktionsfehlerdatei 14₁ .. 14ₘ abgespeichert. Für die Rekonstruktion der Geometrie sind neben der reduzierten zentrierten Basismatrix und den testablaufbezogenen Koeffizientenwerten auch die testablaufbezogenen Rekonstruktionsfehlerelemente e erforderlich. Die Rekonstruktionsfehlerdatei 14 kann mit einer Koeffizientendatei 13, die dem selben Testablauf zugeordnet ist (beide Dateien weisen denselben Testablauf-Index aus 1..m auf) in einer gemeinsamen Containerdatei abgespeichert werden und sind somit stets gemeinsam verfügbar.

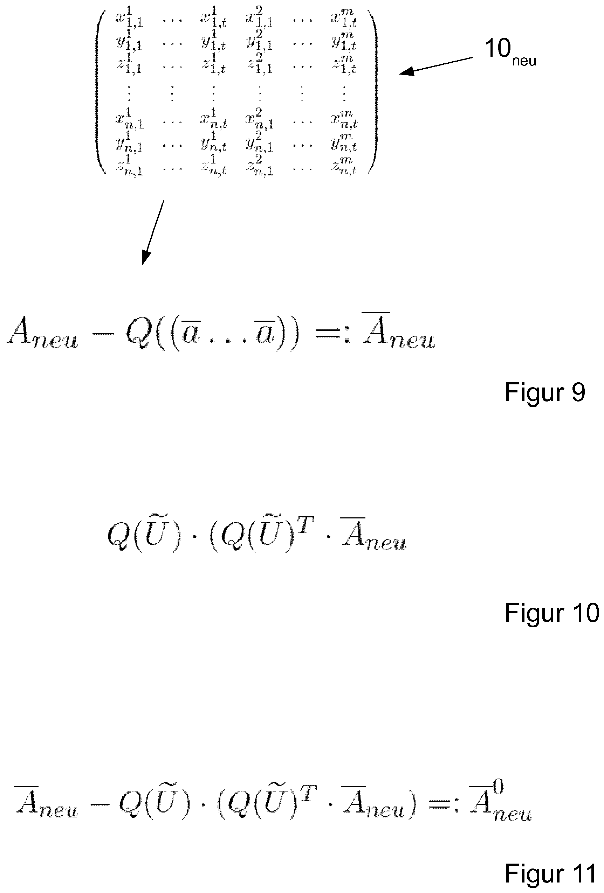

Vorstehend wurde beschrieben, wie aus einer anfänglichen Datenmenge der Geometrieänderung während einer Vielzahl von z.B. Crashsimulationen unterschiedliche Dateien erzeugt werden, anhand denen die Geometrie zu unterschiedlichen Zeitpunkten einer Testreihe rekonstruiert werden kann. Die Architektur der Dateierzeugung lässt es nun zu, dass die abgelegten Daten um Daten weiterer Tests ergänzt werden, ohne dass dafür die bisherigen Daten vollständig neu codiert und erneut abgelegt werden müssen. Die durch die zusätzlichen Tests erzeugten Daten werden in update-Dateien abgelegt, wie anhand der Figuren 9ff nachfolgend erläutert wird.

Aus einem neuen Datensatz 10ₙₑᵤ, der nur die neuen Koordinatenwerte der weiteren Testabläufe umfasst, werden analog zum bereits beschriebenen Vorgehen neue Beobachtungsungsmatrizen Aₙₑᵤ erzeugt (Figur 9). Von jeder Spalte dieser neuen Beobachtungsungsmatrix Aₙₑᵤ wird der bereits vorhandene quantisierte und dequantisierte Mittelwertsvektor Q(a̅) subtrahiert. Das Ergebnis ist eine neue zentrierte Beobachtungsmatrix A̅ₙₑᵤ.

Anschließend erfolgt eine Projektion der neuen zentrierten Beobachtungsmatrix A̅ₙₑᵤ mit der Quantisierung der (alten bzw. initialen) reduzierten Basismatrix Q(Ũ), wobei für diese Projektion die transformierte Quantisierung der Basismatrix Q (Ũ)^{T} verwendet wird. Hiermit lässt sich feststellen, welcher Anteil der neuen zentrierten Beobachtungsmatrix A̅ₙₑᵤ sich durch die (alte, initiale) reduzierte Basismatrix Ũ abbilden lässt. Dieser Teil wird durch den in Figur 10 dargestellten Zusammenhang gebildet. Durch Subtraktion dieses Teils von der neuen zentrierten Beobachtungsmatrix A̅ₙₑᵤ wird diese in das sog. orthogonale Komplement projiziert. Damit werden die Elemente bestimmt, die sich eben nicht durch die vorhandenen Basisvektoren der alten reduzierten Basismatrix Ũ abbilden lassen. Diese Teile werden nun in einer projizierten Beobachtungsmatrix A̅⁰ₙₑᵤ hinterlegt (Figur 11).

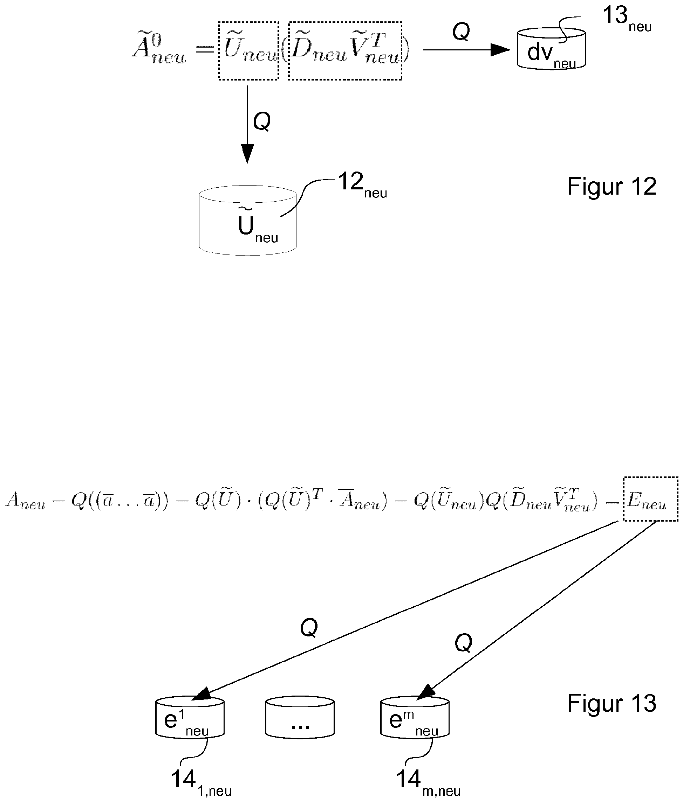

Diese projizierte Beobachtungsmatrix A̅⁰ₙₑᵤ wird nachfolgend einer Hauptkomponentenanalyse unterzogen (Figur 12). Diese wird durchgeführt, wie oben zur zentrierten Beobachtungsmatrix A̅ beschrieben wurde. Analog zur reduzierten Basismatrix Ũ und zur reduzierten Koeffizientenmatrix DṼ^{T} wird eine neue reduzierte Basismatrix Ũₙₑᵤ und eine neue reduzierte Koeffizientenmatrix DṼ^{T}ₙₑᵤ erzeugt. Hieraus wird analog zum bereits zu Figur 8 beschriebenen Verfahren eine neue Rekonstruktionsfehlermatrix Eₙₑᵤ ermittelt (Figur 13). Die einzelnen Elemente e der neuen Rekonstruktionsfehlermatrix Eₙₑᵤ werden testablaufweise in jeweils einer neuen Rekonstruktionsfehlerdatei 14_{1,neu} ,14_{2,neu}, ... abgelegt. Auch diese neue Rekonstruktionsfehlerdatei 14_{..,neu} kann mit der neuen Koeffizientendateien 13ₙₑᵤ, die dem selben Testablauf zugeordnet ist (und daher den selben Testablauf-Index aus 1..m aufweist), in einer gemeinsamen Containerdatei abgespeichert werden.

Die vorgenannten Schritte werden für alle Arbeitsmatrizen A der Knotengruppe und schließlich auch für die Arbeitsmatrizen A aller anderen Knotengruppen durchgeführt.

Im Rahmen des oben beschriebenen Verfahrens werden einzelne Werte einer Quantisierung unterzogen, dabei werden vor allem Werte, die sich geringfügig voneinander unterscheiden, auf einen identischen Wert abgebildet. Diese erhöht eine Häufung von Werten, was im Rahmen einer nachgelagerten Codierung eine höhere Kompressionsrate ermöglicht.

Zur Auswahl der Arbeitsdimension:
Es wird im Rahmen des Schritts nach Figur 5b auf Basis der vorliegenden Daten eine Anzahl an Spalten von der Basismatrix U, eine Anzahl von Zeilen der Koeffizientenmatrix DV^{T} ermittelt sowie eine Anzahl von Diagonaleinträge von D ermittelt, mit denen eine Vorhersage für die Daten der Matrix A gemacht werden kann. Die Arbeitsdimension k entspricht nun dieser Anzahl. Die Auswahl dieser Arbeitsdimension kann auf folgenden Entscheidungskriterien beruhen:
1. Optimierung, bei der alle möglichen Werte von k kleiner oder gleich der Arbeitsdimension der Zeitpunkte und der Dimension der Knoten genommen werden.
2. Eine Quasi-Optimierung bei der nur gewisse Anzahlen von Hauptkomponenten getestet werden (z.B. 1, 3, 5, 7, 11, 15, 19, 27, 35, 43, 59, 75, 91, 123, 155, 187, 251, 315)Zudem wird für den Fall, dass die Anzahl der Zeitpunkte oder die Anzahl der Knoten kleiner als eine der oben genannten Werte ist, die Kompression nicht für diesen Fall getestet, da er lediglich eine Singulärwertzerlegung darstellen würde.
3. Es wird a priori ein Schwellwert vorgegeben und die Anzahl der Hauptkomponenten entspricht der Anzahl der Diagonaleinträge von D die größer oder gleich diesem Schwellwert sind. Dieser Schwellwert kann von einer vorgegebenen Präzision abhängen. Durch die Wahl dieses Schwellwertes wird die Kompressionsrate erheblich beeinflusst

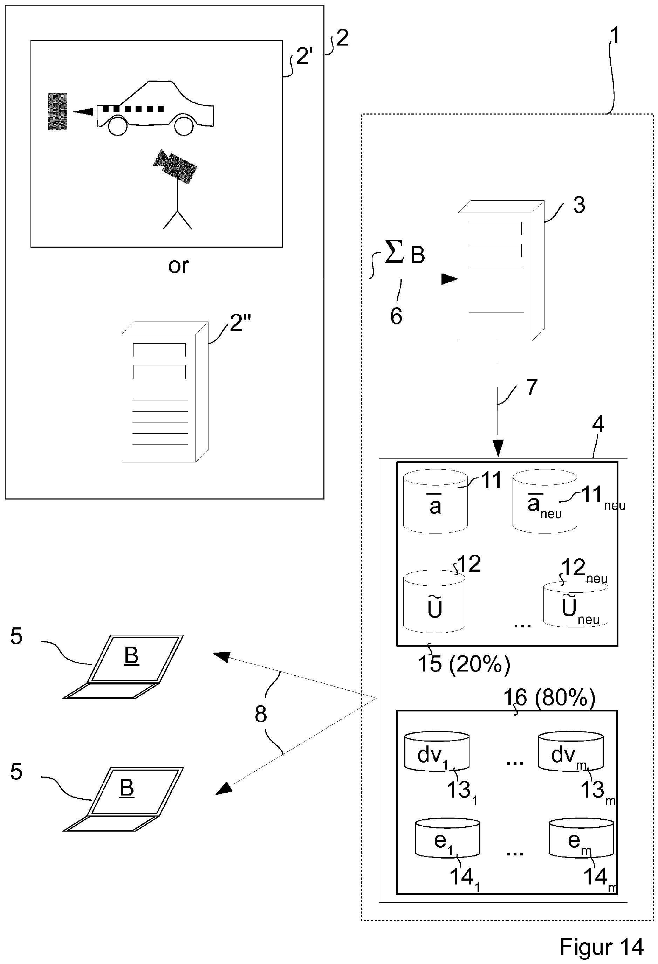

Die Figur 14 zeigt schematisch eine Anordnung eines Fahrzeugcrash - Simulationsdatenmanagementsystems 1 im Umfeld einer Test- und Auswerteumgebung. Es ist eine Datengenerierungseinheit 2 vorgesehen, welche die Menge aller Beobachtungen ∑ B erzeugt. Die Datengenerierungseinheit 2 kann ein realer Testaufbau 2' für beispielsweise einen oder mehrere reale Fahrzeugcrashtest sein. Alternativ kann die Datengenerierungseinheit 2 eine Simulationsumgebung 2" sein, welche z.B. eine Vielzahl von Crashtestsimulationsergebnissen als Beobachtungen ∑ B erzeugt.

Die Summe der zu komprimierenden Beobachtungen ∑ B wird über eine erste Datenverbindung 6 an das Fahrzeugcrash - Simulationsdatenmanagementsystem 1 übergeben. Das Fahrzeugcrash - Simulationsdatenmanagementsystem 1 umfasst eine Datenkompressionseinheit 3 zur Datenkomprimierung der Beobachtungen B, die von der Datengenerierungseinheit 2 bereit gestellt wurden. Diese Datenkompressionseinheit 3 bedient sich dabei dem oben beschriebenen Verfahren. Das Ergebnis dieses Verfahrens sind die einzelnen Dateien 11, 12, 13, 14, die in den einzelnen Schritten (siehe Figuren 5, 7, 8, 12, 13 und zugehörige Beschreibung) erzeugt werden. Diese werden über eine zweite Datenverbindung 7 an eine Speichereinheit 4 übertragen und dort archiviert. Auf diesen dort abgelegten Datenbestand können nun weltweit verteilte Arbeitsstationen 5 über eine dritte Datenverbindung 8 zugreifen, sobald an diesen Arbeitsstationen 5 ausgewählte Beobachtungen B rekonstruiert werden sollen.

Eine weitere Besonderheit an diesem Verfahren und dieser Anordnung liegt darin, dass der in der Speichereinrichtung 4 abgespeicherte komprimierte Datenbestand in zwei Gruppen unterteilt werden kann, nämlich in einen Basisdatenbestand 15 und einen testablaufspezifischen Datenbestand 16.

Der Basisdatenbestand 15 muss im Wesentlichen vollständig in der Arbeitsstation 5 vorliegen, um Beobachtungen von beliebigen Testabläufen dort rekonstruieren zu können. Ausnahme: Die Dateien 11ₙₑᵤ, 12ₙₑᵤ, in denen die reduzierten neuen Basismatrizen sowie neue Mittelwertsvektoren hinterlegt sind, müssen nur dann an der Arbeitsstation 5 verfügbar sein, wenn eine Beobachtung aus diesen neuen Testabläufen rekonstruiert werden soll. Der Basisdatenbestand 15 macht etwa 20% des gesamten Datenbestandes aus.

Der testablaufspezifische Datenbestand 16 umfasst die Elemente der Koeffizientenmatrizen 13 sowie die Elemente 14 der Rekonstruktionsfehlermatrix. Diese Werte sind testablaufspezifisch hinterlegt. Möchte ein Nutzer auf der Arbeitsstation 5 eine Beobachtung aus dem Testablauf 1 (aus der Menge der 1 bis m Testabläufe) rekonstruieren, so benötigt er aus dem testlaufspezifischer Datenbestand 16 lediglich die Koeffizientendatei 13₁ sowie die zugehörige Rekonstruktionsfehlerdatei 14₁. Der gesamte testlaufspezifische Datenbestand 16 (also der testablaufspezifische Datenbestand sämtlicher Testabläufe) macht in Summe etwa 80% des gesamten Datenbestandes aus.

Für eine Synchronisation der Arbeitsstation 5 mit dem Datenbestand ist es zunächst erforderlich, dass der Basisdatenbestand 15 auf die Arbeitsstation 5 übertragen wird. Dies kann in Zeiten schwacher Netzauslastung erfolgen, z.B. nachts oder an Feiertagen. Möchte nun der Nutzer an der Arbeitsstation 5 eine spezifische Beobachtung B rekonstruieren, so kann er kurzfristig die entsprechenden testlaufspezifischen Dateien 13, 14 abrufen. Zwar macht der gesamte testlaufspezifische Datenbestand 16 etwa 80% der gesamten Datenbestandes aus; der testablaufspezifische Datenbestand eines einzigen Testablaufs hingegen umfasst aber nur einige MByte bis wenige GByte und ist daher in wenigen Sekunden bis Minuten von der Speichereinheit auch über eine Internetverbindung zu beziehen.

Die gezeigten Datenverbindungen 6, 7, 8 können Datenfernverbindungen sein. Als Datenfernverbindung wird eine Datenverbindung angesehen, die mehr als 100 km Distanz überwindet und/oder über das Internet bereitgestellt wird. Insbesondere ist die dritte Datenverbindung eine solche Datenfernverbindung. So ist es möglich, dass der komprimierte Datenbestand an einem einzigen Ort hinterlegt ist, aber von Arbeitsstationen 5 an unterschiedlichsten Orten der Welt abrufbar ist. Automobilkonzerne verfügen heutzutage über eine Vielzahl von weitverteilten Entwicklungs- und Forschungsstandorten, die allesamt Zugriff auf den abgelegten Datenbestand benötigen. Durch das erfindungsgemäße Verfahren zum Betreiben eines Testdatenmanagementsystems 1 kann so definiert auf einen relevanten Teil des Datenbestandes zugegriffen werden, um einzelne Beobachtungen B rekonstruieren zu können.

Über die erste Datenverbindung werden insbesondere recht große Datenmengen übertragen; insofern ist es bevorzugt, dass die Datengenerierungseinheit 2 und die Datenkomprimierungseinheit 3 nahe beieinander angeordnet sind. Die Speichereinheit 4 kann wiederum über eine Datenfernverbindung 7 mit der Datenkomprimierungseinheit 3 verbunden sein, da hierüber die durch das vorbeschriebene Verfahren komprimierten Daten versendet werden. So können Beobachtungen aus einer Vielzahl von weit verteilten Test- oder Simulationseinrichtungen 2 gesammelt werden und zentral an einem Ort gespeichert werden.

Zur Aufteilung der Knotenpunkte in Knotengruppen:
Im Rahmen des vorliegenden Verfahrens werden Teile aller Knoten separat in Knotengruppen zusammengefasst und das Komprimierungsverfahren für jede dieser Knotengruppen separat durchgeführt. Geeignete Gruppen lassen sich wieder auf verschiedene Arten bestimmen.
Komplexe Objekte (zum Beispiel Fahrzeuge), sind aus der Konstruktion heraus bereits in Bauteile zerlegt. Diese Zerlegung in Bauteile stellt eine natürliche Aufteilung dar, die für die Gruppeneinteilung benutzt werden kann. Sind Bauteile zu klein (enthalten zum Beispiel weniger als 100 Gitterpunkte) so können diese einem Nachbarbauteil, zum Beispiel dem mit der geringsten eigenen Knotenzahl zugeschlagen werden.

Liegt eine Unterteilung in Bauteile nicht vor oder liegt die Zahl der Knotenpunkte für ein Bauteil über einem Schwellwert, so kann das Gesamte Objekt oder das Bauteil weiter unterteilt werden. Das kann z.B. durch Aufteilung eines alle Knoten umfassenden Rechteckgebietes mittels eines Octrees (Oktalbaums) derart, erfolgen dass die in ein Teilgebiet entfallenden Knotenpunkte einem Bauteil zugeordnet werden. Dabei wird die Aufteilung entweder so gewählt, das die Größe aller Teilgebiete gleich ist oder das in jedem Teilgebiet höchstens eine maximale Zahl von Knotenpunkte enthalten ist. Verändert sich die Position der Knotenpunkte über der Zeit, so wird die Ausgangsposition zur Identifikation eines Knotens mit einem Gebiet genommen. Eine andere Unterteilung kann durch eine Zerlegungsmethode, die möglichst eng miteinander vernetze Knotenpunkte zusammen lässt, erreicht werden. Hier bieten sich zum Beispiel die Recursive Spectral Bisection oder verwandte Verfahren an.

Eine andere Methode zur Zerlegung in Teilgebiete insbesondere für größere Bauteile ist die Independent Component Analysis (ICA). Diese kann zur Zerlegung in Teilgebiete genutzt werden. Betrachtet man ein Merkmal der Simulation, wie zum Beispiel die Verformung für alle Zeitpunkte, und stellt mittels der ICA fest, dass sich Teilgebiete unterschiedlich verhalten, dann kann man das Modell oder die Bauteile anhand dieser identifizierten Teilgebiete zerlegen. Die vorgenannten Aufteilungsverfahren können kombiniert werden, indem zum Beispiel auf eine Aufteilung der Knoten in Bauteile einige oder alle Bauteile mittels eines Oktalbaums zerlegt werden.

Stimmen die Modelle, für die jeweils die Simulation durchgeführt wird, geometrisch nicht überein, so führt man eine Gebietszerlegung mit einem der oben genannten Ansätze durch und komprimiert in denjenigen Teilgebieten die Simulationsergebnisse gemeinsam, für die das zugehörige Modell übereinstimmt. Eine weitere Möglichkeit Simulationen mit unterschiedlichen Geometrien zu komprimieren ist, Strukturen zu identifizieren, die bei mehreren Modellen vorkommen. Dazu bestimmt man für jeden vorhandenen Knotenpunkt, in wie vielen Simulationsmodellen in der Ausgangskonfiguration an dieser Stelle ein Knotenpunkt ist. Zum Beispiel mit Hilfe eines Greedy Verfahrens kann man dann möglichst große Bereiche bestimmen in denen für alle oder eine bestimmte Teilmenge der Modelle die Knotenpunkte übereinstimmen.

Wenn im Rahmen der vorliegenden Anmeldung von Spalten und Zeilen die Rede ist, dann ist es unrelevant, ob Spalten nun vertikal Zeilen horizontal dargestellt werden. In einer transponierten Darstellung können Zeilen auch vertikal und Spalten horizontal dargestellt sein.

Die Begriffe "Kompression" und "Komprimierung" werden im Rahmen dieser Erfindung synonym verwendet.

### Bezugszeichenliste

- 1: Simulationsdatenmanagmentsystem
- 2: Datengenerierungseinheit (realer Testaufbau bzw. Simulationsrechner)
- 3: Datenkompressionseinheit
- 4: Speichereinheit
- 5: Arbeitsstation
- 6: erste Datenverbindung
- 7: zweite Datenverbindung
- 8: dritte Datenverbindung

- 10: Datensatz
- 11: Mittelwertdatei
- 12: Basismatrixdatei
- 13: Koeffizientendatei
- 14: Rekonstruktionsfehlerdatei
- 15: Basisdatenbestand
- 16: testablaufspezifischer Datenbestand

- x, y, z, a: Koordinate
- x, y, z: Raumkoordinate
- B: Beobachtung
- m: Anzahl der Testabläufe des Datenbestandes
- n: Anzahl der Gruppen
- t: Anzahl von Zeitpunkten
- A: Beobachtungsmatrix
- DV^{T}: Koeffizientenmatrix
- dv: Element der Koeffzientenmatrix (Koeffizient)
- U: Basismatrix
- Q: Quantisierungsschritt
- k: Arbeitsdimension
- E: Rekonstruktionsfehlermatrix
- e: Element der Rekonstruktionsfehlermatrix (Fehlerwert)

## Patentansprüche

1. Verfahren zum Betreiben eines Fahrzeugcrash-Testdatenmanagementsystems (1), insbesondere eines Fahrzeugcrash-Simulationsdatenmanagementsystems,
das Fahrzeugcrash-Testdatenmanagementsystem (1) umfassend:
eine Datenkompressionseinheit (3) zur Datenkompression von Beobachtungen (B) einer Vielzahl von Fahrzeugcrash-Testabläufen zu einem oder mehreren Beobachtungspunkten, insbesondere Zeitpunkten, die insbesondere von einer Datengenerierungseinheit (2) bereitgestellt werden,
wobei die Geometrie von Bauteilen des Fahrzeugs oder des vollständigen Fahrzeugs durch Bildung finiter Elemente als Gitter mit einer Vielzahl von Knotenpunkten und Kanten approximiert wird, wobei die Knotenpunkte und Kanten des Gitters die Instanzen des Gitters bilden, und wobei die Beobachtungen (B) Instanzenkoordinaten (a, x, y, z) von Instanzen eines oder mehrerer Gitter umfassen und jede Instanzenkoordinate (a, x, y, z) jeweils einem Beobachtungspunkt, insbesondere einem Zeitpunkt (1..t), eines Testablaufs (1..m) zugeordnet ist,
eine Speichereinheit (4) zum Abspeichern der von der Datenkompressionseinheit (3) mittels der Datenkompression von Beobachtungen (B) erzeugten Basismatrizen (Ũ; Q(Ũₙₑᵤ), Üₙₑᵤ) und Koeffizientenmatrizen (DṼ^{T}),
das Verfahren umfassend die folgenden Schritte:
i) Komprimieren von Beobachtungen (B) mittels der Datenkompressionseinheit (3) durch:
Aufteilen von Instanzen des Gitters in mehrere Instanzengruppen (1..n) und Erzeugen einer Vielzahl von gruppenbezogenen Datensätzen (10) aus den Beobachtungen, wobei aus den Beobachtungen (B) die Instanzenkoordinaten der Instanzen einer gemeinsamen Istanzengruppe in gruppenbezogenen Datensätzen (10) zusammengefasst werden;
Für jeden gruppenbezogenen Datensatz (10):
Extrahieren der Instanzenkoordinaten des gruppenbezogenen Datensatzes (10) für jede Koordinatenart (a, x, y, z) separat und Zusammenfassen der so extrahierten koordinatenartbezogenen und gruppenbezogenen Instanzenkoordinaten in jeweils einer Beobachtungsmatrix (Aₐ, Aₓ, A_{y}, A_{z}),
Für jede der koordinatenart- und gruppenbezogenen Beobachtungsmatrizen (Aₐ, Aₓ, A_{y}, A_{z}):Bestimmen
einer Basismatrix (U), deren Spalten zumindest die Teilmenge einer Basis,
insbesondere Orthonormalbasis, der jeweiligen Beobachtungsmatrix (A) bilden, und - einer Koeffizientenmatrix (DV^{T}), als eine Gewichtung der Spalten der Basismatrix (U),
insbesondere durch Durchführen einer vollständigen oder teilweisen Hauptkomponentenanalyse (PCA) für die koordinatenart- und gruppenbezogenen Beobachtungsmatrizen (Aₐ, Aₓ, A_{y}, A_{z}),
Bestimmen einer Arbeitsdimension (k) und Reduzieren der Basismatrix (U) auf eine reduzierte Basismatrix (Ü) mit einer Anzahl von Spalten entsprechend der Arbeitsdimension (k) und Reduzieren der Koeffizientenmatrix (DV^{T}) auf eine reduzierte Koeffizientenmatrix (DṼ^{T}) mit einer Anzahl von Zeilen entsprechend der Arbeitsdimension (k),
ii) Speichern der erzeugten reduzierten Basismatrix (Ũ) und der reduzierten Koeffizientenmatrix (DṼ^{T}) in der Speichereinheit (4);
wobei der in der Speichereinheit (4) abgespeicherte komprimierte Datenbestand in zwei Gruppen unterteilt ist, nämlich in einen Basisdatenbestand (15) umfassend die reduzierten Basismatrizen (12, 12ₙₑᵤ und in einen testablaufspezifischen Datenbestand (16) umfassend die reduzierten Koeffizientenmatrizen (13_{1,...,m});
wobei die reduzierten Basismatrizen (Ũ) separat von den reduzierten Koeffizientenmatrizen (DṼ^{T}), insbesondere verlustbehaftet komprimiert, in einer Basismatrixdatei (12), abgespeichert werden,
und wobei die Werte (dv) der reduzierten Koeffizientenmatrix (DṼ^{T}) für jeden Testablauf, insbesondere verlustbehaftet komprimiert, in jeweils einer Koeffizientendatei (13_{1,}.. 13ₘ) separat abgespeichert;
iii) Übertragen - zur Rekonstruktion einer ausgewählten Beobachtung (B) aus einem Testablauf an einer Arbeitsstation (5), an der die Basismatrixdatei (12) im Wesentlichen vollständig vorliegt, - der lediglich diesem Testablauf entsprechenden Koeffizientendatei (13₁ ... 13ₘ) von der Speichereinheit (4) zu der Arbeitsstation (5).

2. Verfahren nach dem vorherigen Anspruch,
**dadurch gekennzeichnet,**
**dass** die Beobachtungsmatrix (A) vor der Bestimmung der Basismatrix (U) und der Koeffizientenmatrix (DV^{T}) zentriert wird, wobei Mittelwerte (a) jeder Zeile von den Koordinaten der entsprechenden Zeilen subtrahiert werden.

3. Verfahren nach einem der vorherigen Ansprüche,
**dadurch gekennzeichnet,**
**dass** sämtliche Werte der reduzierten Basismatrix (Ũ) gemeinsam abgespeichert werden.

4. Verfahren nach Anspruch 2,
**dadurch gekennzeichnet,**
**dass** durch Multiplikation der reduzierten, und insbesondere verlustbehaftet komprimiert und dekomprimierten, Basismatrix (Ũ) mit der reduzierten und, insbesondere verlustbehaftet komprimiert und dekomprimierten, Koeffizientenmatrix (DṼ^{T}) eine Approximationsmatrix (Ã) der jeweiligen Beobachtungsmatrizen (A) erzeugt wird,
und **dass** eine Fehlermatrix (E) dadurch ermittelt wird, dass von der Beobachtungsmatrix (A) zum einen die Approximationsmatrix (Ã) und zum anderen spaltenweise der Vektor der Mittelwerte (a̅) subtrahiert wird.

5. Verfahren nach Anspruch 4,
**dadurch gekennzeichnet,**
**dass** Fehlerwerte (e) der Fehlermatrix (E) für jeden Testablauf separat abgespeichert werden.

6. Verfahren nach einem der vorherigen Ansprüche,
**dadurch gekennzeichnet,**
**dass** Werte zur, insbesondere approximativen, Rekonstruktion von Beobachtungen von weiteren Testabläufen ausschließlich in separaten Dateien (12ₙₑᵤ, 13ₙₑᵤ, 14ₙₑᵤ) abgelegt werden.

7. Verfahren nach einem der vorherigen Ansprüche,
**dadurch gekennzeichnet,**
**dass** anhand einer Projektion (A̅⁰ₙₑᵤ) einer neuen, insbesondere zentrierten, Beobachtungsmatrix (A̅ₙₑᵤ) umfassend Koordinatenwerte eines neuen Datensatzes (10ₙₑᵤ), mit der reduzierten Basismatrix (Q(Ũ); (Ũ), die lediglich den Ursprungsdatensatzes (10) berücksichtigt, eine neue, insbesondere reduzierte, Basismatrix (Q(Ũₙₑᵤ); (Ũₙₑᵤ) erzeugt wird, die lediglich Basisvektoren umfasst, die von der reduzierten Basismatrix (Q(Ũ); (Ũ)) nicht mitumfasst sind.

8. Verfahren nach dem vorherigen Anspruch,
**dadurch gekennzeichnet,**
**dass** anhand der Projektion (A̅⁰ₙₑᵤ) eine neue reduzierte Koeffizientenmatrix (DṼ^{T}ₙₑᵤ) erzeugt wird.

9. Verfahren nach einem der vorherigen Ansprüche,
**dadurch gekennzeichnet,**
**dass** für einzelne Testabläufe die Basismatrizen oder Werte von Koeffizienten, die sich auf unterschiedliche Instanzengruppen beziehen, in jeweils gemeinsamen, instanzgruppenübergreifenden Dateien abgespeichert werden.

10. Verfahren nach einem der vorherigen Ansprüche, wobei das Datenbankmanagementsystem (1) über eine Datenfernverbindung (8) mit der Arbeitsstation (5) verbunden ist.

## Claims

1. Method for operating a vehicle crash test data management system (1), in particular a vehicle crash simulation data management system,
the vehicle crash test data management system (1) comprising:
a data compression unit (3) for compressing data from observations (B), a multiplicity of vehicle crash test runs relating to one or more observation points, in particular points in time, which are provided, in particular, by a data generating unit (2),
wherein the geometry of components of the vehicle or of the entire vehicle is approximated by forming finite elements as a lattice with a multiplicity of nodes and edges, wherein the nodes and edges of the lattice form the instances of the lattice, and wherein the observations (B) comprise instance coordinates (a, x, y, z) of instances of one or more lattices, and each instance coordinate (a, x, y, z) is respectively assigned to an observation point, in particular a point in time (1..t), of a test run (1..m),
a memory unit (4) for storing the basic matrices (Ũ; Q(Ũₙₑᵤ), Üₙₑᵤ) and coefficient matrices (DṼ^{T}) generated by the data compression unit (3) by performing data compression on observations (B),
the method comprising the following steps:
i) compressing observations (B) by means of the data compression unit (3) by:
dividing instances of the lattice into a plurality of instance groups (1..n) and generating a multiplicity of group-related datasets (10) from the observations,
wherein the instance coordinates of the instances of a common instance group from the observations (B) are combined in group-related datasets (10);
for each group-related dataset (10):
extracting the instance coordinates of the group-related dataset (10) for each type of coordinate (a, x, y, z) separately, and combining the coordinate-related and group-related instance coordinates which have been extracted in this way into one respective observation matrix (Aₐ, Aₓ, A_{y}, A_{z}),
for each type of coordinate-type-related and group-related observation matrix (Aₐ, Aₓ, A_{y}, A_{z}) : determining a basic matrix (U) whose columns form at least the subset of a base, in particular orthonormal base, of the respective observation matrix (A), and
- a coefficient matrix (DV^{T}) as a weighting of the columns of the basic matrix (U),
in particular by carrying out a complete or partial principal component analysis (PCA) for the coordinate-type-related and group-related observation matrices (Aₐ, Aₓ, A_{y}, A_{z}),
determining a working dimension (k) and reducing the basic matrix (U) to a reduced basic matrix (U) with a number of columns corresponding to the working dimension (k) and reducing the coefficient matrix (DV^{T}) to a reduced coefficient matrix (DṼ^{T}) with a number of rows corresponding to the working dimension (k),
ii) storing the generated reduced basic matrix (Ũ) and the reduced coefficient matrix (DṼ^{T}) in the memory unit (4) ;
wherein the compressed data stock which is stored in the memory unit (4) is divided into two groups, specifically into a basic data stock (15) comprising the reduced basic matrices (12, 12ₙₑᵤ) and into a test-run-specific data stock (16) comprising the reduced coefficient matrices (13_{1,...,m});
wherein the reduced basic matrices (Ũ) are compressed separately from the reduced coefficient matrices (DṼ^{T}), in particular in a lossy fashion, and stored in a basic matrix file (12),
and wherein the values (dv) of the reduced coefficient matrix (DṼ^{T}) for each test run are compressed, in particular in a lossy fashion, and stored separately in a respective coefficient file (13₁,.. 13ₘ);
iii) transmitting, for the purpose of reconstructing a selected observation (B) from a test run at a workstation (5) at which the basic matrix file (12) is essentially completely present, the coefficient file (13₁ ... 13ₘ) which corresponds only to this test run from the memory unit (4) to the workstation (5).

2. Method according to the preceding claim,
**characterized**
**in that** the observation matrix (A) is centred before the determination of the basic matrix (U) and the coefficient matrix (DV^{T}), wherein mean values (a) of each row are subtracted from the coordinates of the corresponding rows .

3. Method according to one of the preceding claims,
**characterized**
**in that** all the values of the reduced basic matrix (Ũ) are stored together.

4. Method according to Claim 2,
**characterized**
**in that** by multiplying the basic matrix (Ũ) which has been reduced and, in particular, compressed and decompressed in a lossy fashion, by the coefficient matrix (DṼ^{T}) which has been compressed and decompressed in particular in a lossy fashion, an approximation matrix (Ã) of the respective observation matrices (A) is generated,
and **in that** an error matrix (E) is determined by virtue of the fact that, on the one hand, the approximation matrix (Ã) is subtracted from the observation matrix (A), and on the other hand the vector of the mean values (a̅) is subtracted column by column from the observation matrix (A).

5. Method according to Claim 4,
**characterized**
**in that** error values (e) of the error matrix (E) are stored separately for each test run.

6. Method according to one of the preceding claims,
**characterized**
**in that** values relating to the, in particular approximate, reconstruction of observations of further test runs are stored exclusively in separate files (12ₙₑᵤ, 13ₙₑᵤ, 14ₙₑᵤ).

7. Method according to one of the preceding claims,
**characterized**
**in that** a new, in particular, reduced basic matrix (Q(Ũₙₑᵤ); (Ũₙₑᵤ)) is generated on the basis of a projection (A̅⁰ₙₑᵤ) of a new, in particular centred, observation matrix (A̅ₙₑᵤ) comprising coordinate values of a new dataset (10ₙₑᵤ), with the reduced basic matrix (Q(Ũ); (Ũ) ) which takes into account only the origin dataset (10), said basic matrix (Q(Ũₙₑᵤ); (Ũₙₑᵤ)) comprising only basic vectors which are not included in the reduced basic matrix (Q(Ũ); (Ũ)).

8. Method according to the preceding claim,
**characterized**
**in that** a new reduced coefficient matrix (DṼ^{T}ₙₑᵤ) is generated on the basis of the projection (A̅⁰ₙₑᵤ).

9. Method according to one of the preceding claims,
**characterized**
**in that** for individual test runs the basic matrices or values of coefficients which relate to different instance groups are stored in respective common files containing multiple instance groups.

10. Method according to one of the preceding claims, wherein the database management system (1) is connected to the workstation (5) via a remote data connection (8).

## Revendications

1. Procédé de fonctionnement d'un système de gestion de données de test de collision de véhicules (1), en particulier d'un système de gestion de données de simulation de collision de véhicules, le système de gestion de données de test de collision de véhicules (1) comprenant :
une unité de compression de données (3) destinée à la compression de données d'observations (B) d'un grand nombre de séquences de test de collision de véhicules en un ou plusieurs points d'observation, en particulier des instants qui sont notamment fournis par une unité de génération de données (2),
la géométrie de composants du véhicule ou du véhicule complet étant approximée par formation d'éléments finis sous la forme d'une grille pourvue d'une pluralité de nœuds et de bords, les nœuds et les bords de la grille formant les instances de la grille, et les observations (B) comprenant des coordonnées (a, x, y, z) d'instances d'une ou plusieurs grilles et chaque coordonnée d'instance (a, x, y, z) étant associée à un point d'observation, en particulier un instant (l...t), d'une séquence de test (1...m),
une unité de mémorisation (4) destinée à mémoriser les matrices de base (Ũ; Q(Ũₙₑᵤ), Üₙₑᵤ) et les matrices de coefficients (DṼ^{T}) générées par l'unité de compression de données (3) au moyen de la compression de données d'observations (B),
le procédé comprenant les étapes suivantes :
i) comprimer des observations (B) au moyen de l'unité de compression de données (3) par :
division d'instances de la grille en plusieurs groupes d'instances (1...n) et génération d'une multitude d'ensembles de données (10) liés aux groupes à partir des observations, les coordonnées des instances d'un groupe d'instances commun étant rassemblées en ensembles de données (10) liés aux groupes à partir des observations (B) ;
pour chaque ensemble de données (10) lié aux groupes :
extraire les coordonnées d'instance de l'ensemble de données (10) lié aux groupes pour chaque type de coordonnées (a, x, y, z) séparément et rassembler les coordonnées d'instance ainsi extraites liées aux types de coordonnées et liées aux groupes en une matrice d'observation (Aₐ, Aₓ, A_{y}, A_{z}),
pour chacune des matrices d'observation liées aux types de coordonnées et liées aux groupes (Aₐ, Aₓ, A_{y}, A_{z}) :
déterminer
- une matrice de base (U) dont les colonnes forment au moins le sous-ensemble d'une base, en particulier d'une base orthonormée, de la matrice d'observation respective (A), et
- une matrice de coefficients (DV^{T}), comme pondération des colonnes de la matrice de base (U),
notamment par une analyse de composantes principales (ACP) complète ou partielle pour les matrices d'observation liées aux types de coordonnées et liées aux groupes (Aₐ, Aₓ, A_{y}, A_{z}),
déterminer une dimension de travail (k) et réduire la matrice de base (U) à une matrice de base réduite (Ü) ayant un nombre de colonnes correspondant à la dimension de travail (k) et réduire la matrice de coefficients (DV^{T}) à une matrice de coefficients réduite (DṼ^{T}) ayant un nombre de lignes correspondant à la dimension de travail (k),
ii) mémoriser la matrice de base réduite générée (Ũ) et la matrice de coefficients réduite (DṼ^{T}) dans l'unité de mémorisation (4) ;
l'ensemble de données compressé mémorisé dans l'unité de mémorisation (4) étant divisé en deux groupes, à savoir en un ensemble de données de base (15) comprenant les matrices de base réduites (12, 12ₙₑᵤ) et
un ensemble de données (16) spécifiques à la séquence de test et comprenant les matrices de coefficients réduites (13_{1, ..., m)};
les matrices de base réduites (Ũ) étant mémorisées séparément des matrices de coefficients réduites (DṼ^{T}), notamment compressées avec perte, dans un fichier de matrices de base (12),
et les valeurs (dv) de la matrice de coefficients réduite (DṼ^{T}) pour chaque séquence de test, en particulier compressée avec perte, étant mémorisées chacune séparément dans un fichier de coefficients (13₁, ...13ₘ);
iii) pour reconstruire une observation sélectionnée (B) à partir d'une séquence de test à un poste de travail (5) où le fichier de matrices de base (12) est sensiblement entièrement disponible, transférer le fichier de coefficients (13₁ ... 13ₘ), correspondant uniquement à cette séquence de test, de l'unité de mémorisation (4) au poste de travail (5).

2. Procédé selon la revendication précédente,
**caractérisé en ce que**
la matrice d'observation (A) est centrée avant la détermination de la matrice de base (U) et de la matrice de coefficients (DV^{T}), les valeurs moyennes (a) de chaque ligne étant soustraites des coordonnées des lignes correspondantes.

3. Procédé selon l'une des revendications précédentes,
**caractérisé en ce que**
toutes les valeurs de la matrice de base réduite (Ũ) sont mémorisées ensemble.

4. Procédé selon la revendication 2,
**caractérisé en ce que**
une matrice d'approximation (Ã) des matrices d'observation respectives (A) est générée par multiplication de la matrice de base réduite (Ũ), et en particulier compressée et décompressée avec perte, par la matrice de coefficients réduite (DṼ^{T}), en particulier compressée et décompressée avec perte,
et **en ce qu'**une matrice d'erreur (E) est déterminée par soustraction de la matrice d'approximation (Ã) d'une part et du vecteur des valeurs moyennes (a̅) d'autre part de la matrice d'observation (A).

5. Procédé selon la revendication 4,
**caractérisé en ce que**
les valeurs d'erreur (e) de la matrice d'erreur (E) sont mémorisées séparément pour chaque séquence de test.

6. Procédé selon l'une des revendications précédentes,
**caractérisé en ce que**
les valeurs destinées à la reconstruction, notamment approximative, des observations d'autres séquences de test sont mémorisées exclusivement dans des fichiers séparés (12ₙₑᵤ, 13ₙₑᵤ, 14ₙₑᵤ).

7. Procédé selon l'une des revendications précédentes,
**caractérisé en ce que**
une nouvelle matrice de base (Q(Ũₙₑᵤ); (Ũₙₑᵤ), notamment réduite, qui ne comprend que des vecteurs de base qui ne sont pas inclus dans le matrice de base (Q(Ũ); (Ũ)), est générée sur la base d'une projection (A̅⁰ₙₑᵤ) d'une nouvelle matrice d'observation (A̅ₙₑᵤ), notamment centrée, comprenant des valeurs de coordonnées d'un nouvel ensemble de données (10ₙₑᵤ), avec la matrice de base réduite (Q(Ũ); (Ũ)), qui ne prend en compte que l'ensemble de données d'origine (10).

8. Procédé selon la revendication précédente,
**caractérisé en ce que**
une nouvelle matrice de coefficients réduite (DṼ^{T}ₙₑᵤ) est générée sur la base de la projection (A̅⁰ₙₑᵤ).

9. Procédé selon l'une des revendications précédentes,
**caractérisé en ce que**
pour des séquences de test individuelles les matrices de base ou les valeurs de coefficients, qui se rapportent à différents groupes d'instances, sont mémorisées dans des fichiers communs couvrant tous les groupes d'instances.

10. Procédé selon l'une des revendications précédentes, le système de gestion de base de données (1) étant relié au poste de travail (5) par une liaison de données à grande distance (8).
